# EUROPEAN PATENT APPLICATION

(11) **EP 4 766 030 A1**
(43) Date of publication of application: **24.06.2026**
(21) Application number: 24909729.6
(22) Date of filing: 30.07.2024
(51) Int. Cl.: H05K 1/02

(54) **CIRCUIT BOARD AND ELECTRONIC DEVICE**

(30) Priority: 27.12.2023 CN 202311820711
(71) Applicant: Honor Device Co., Ltd., Shenzhen, Guangdong 518040 (CN)
(72) Inventor: DONG, Xiaoyong, Shenzhen, Guangdong 518040 (CN)
(74) Representative: Isarpatent
(86) International application number: PCT/CN2024/108454
(87) International publication number: WO 2025/138775

(57) **Abstract**

This application relates to the technical field of electronic devices, and discloses a circuit board and an electronic device. The electronic device includes the circuit board, a rotating shaft mechanism, a first body, and a second body. The first body and the second body are rotatably connected through a connection assembly of the rotating shaft mechanism, and can rotate relative to each other about an axis extending along a first direction. The circuit board includes a first extension segment, a connection segment, and a second extension segment that are successively connected. The first extension segment and the second extension segment respectively extend to the first body and the second body. The connection segment extends through the rotating shaft mechanism, and the connection segment includes a first sub-segment and a second sub-segment that are disposed at an interval along the first direction. The first sub-segment and the second sub-segment both connect the first extension segment and the second extension segment, and are located along the first direction on opposite sides of the center of the electronic device along the first direction. The connection assembly of the rotating shaft mechanism includes a first connection assembly, and the first connection assembly is disposed between the first sub-segment and the second sub-segment along the first direction, thereby enhancing strength of the electronic device.

## Description

This application claims priority to Chinese Patent Application No. 202311820711.9, filed with the China National Intellectual Property Administration on December 27, 2023 and entitled "CIRCUIT BOARD AND ELECTRONIC DEVICE", which is incorporated herein by reference in its entirety.

### TECHNICAL FIELD

This application relates to the technical field of electronic devices, and in particular, to a circuit board and an electronic device.

### BACKGROUND

Folded electronic devices are favored by a large number of users because they have large display screens and are easy to be carried. A folded electronic device generally includes a rotating shaft mechanism, and two bodies that are rotatably connected through the rotating shaft mechanism. A through-shaft circuit board may extend from one body to the other body through the rotating shaft mechanism, and is electrically connected to electronic components (such as a circuit board, a chip, a processor, a battery, and the like) in the two bodies, so that the electronic components in the two bodies can perform signal transmission.

A current solution in which a through-shaft circuit board passes through a rotating shaft mechanism (a "through-shaft solution" for short) reduces strength of an electronic device, causing the electronic device to easily deform.

### SUMMARY

To resolve the foregoing technical problem, this application provides a circuit board and an electronic device. The following describes this application from a plurality of aspects. For implementations and beneficial effects of the following plurality of aspects, references may be made to each other.

A firs aspect of this application provides an electronic device. The electronic device includes a first body, a second body, a rotating shaft mechanism, and a circuit board. The first body is connected to the second body through the rotating shaft mechanism, to rotate relative to the second body about an axis extending along a first direction. The rotating shaft mechanism includes at least one group of connection assembly that rotatably connects the first body and the second body, and the at least one group of connection assembly includes a first connection assembly. The circuit board includes a first extension segment, a connection segment, and a second extension segment that are successively connected. The connection segment includes a first sub-segment and a second sub-segment that are disposed at an interval along the first direction. Two ends of the first sub-segment are respectively connected to the first extension segment and the second extension segment, and two ends of the second sub-segment are respectively connected to the first extension segment and the second extension segment. The first extension segment and the second extension segment respectively extend into the first body and the second body. The connection segment extends through the rotating shaft mechanism, and along the first direction, the first sub-segment and the second sub-segment of the connection segment are respectively located on opposite sides of a center of the electronic device along the first direction. The first connection assembly is disposed between the first sub-segment and the second sub-segment of the connection segment along the first direction.

In the foregoing electronic device, the connection segment of the circuit board adopts a bifurcated design, and includes the first sub-segment and the second sub-segment. In this way, the first sub-segment and the second sub-segment of the connection segment may be respectively disposed on opposite sides of the center of the electronic device along the first direction, so that the connection segment of the circuit board can avoid a center position of the electronic device. In this way, the first connection assembly may be arranged at a center position of the rotating shaft mechanism, so as to provide a fulcrum for the center position of the electronic device. Therefore, support strength of the rotating shaft mechanism for the first body and the second body at the center position of the electronic device can be effectively enhanced, thereby enhancing strength of the electronic device. An overall deformation resistance capability of the electronic device is relatively good.

In a possible implementation of the first aspect, the first extension segment includes a first end and a second end that are disposed at an interval along the first direction, and the second extension segment includes a first end and a second end that are disposed at an interval along the first direction. The two ends of the second sub-segment are respectively connected to the first end of the first extension segment and the first end of the second extension segment, and along the first direction, the second end of the first extension segment and the second end of the second extension segment are both located on a side, facing away from the second sub-segment, of the first sub-segment.

In this way, after the circuit board is mounted in the electronic device, more stack space can be saved for other electronic components, which is beneficial to a thinning design of the electronic device.

In a possible implementation of the first aspect, the circuit board includes a first trace and a second trace, and a length of the first trace is less than a length of the second trace. The first trace extends from the second end of the first extension segment to the second end of the second extension segment via the first sub-segment of the connection segment, and the first trace is configured to transmit one of the following signals: a high-speed signal and a high-current power supply signal. The second trace extends from the second end of the first extension segment to the second end of the second extension segment via the second sub-segment of the connection segment, and the second trace is configured to transmit one of the following signals: a low-speed signal, a digital signal, a small-current power supply signal, and an analog-to-digital converter signal.

In the foregoing circuit board, the first trace is configured to transmit a signal greatly affected by a trace length. Because the length of the first trace is relatively small, this can effectively reduce a parasite induction, a parasite capacitance, and a low-frequency impedance of the first trace, thereby effectively improving a signal transmission effect. The second trace is configured to transmit a signal insensitive to the trace length. Therefore, even if the length of the second trace is relatively long, this will not affect an actual functional module or actual detection. In conclusion, the signal transmission effect of the circuit board is effectively improved.

In a possible implementation of the first aspect, the circuit board is a flexible printed circuit.

In a possible implementation of the first aspect, the first connection assembly is located at the center of the electronic device along the first direction. That is, the first connection assembly is disposed in the middle of the electronic device. In this way, connection reliability of the rotating shaft mechanism, the first body, and the second body at the center position of the electronic device can be further improved, so that the strength of the electronic device is better.

In a possible implementation of the foregoing first aspect, the first connection assembly includes a first swing arm and a second swing arm, and the first connection assembly is connected to the first body through the first swing arm, and is connected to the second body through the second swing arm. A material of the first swing arm and the second swing arm is a powder metallurgy material or an aluminum profile.

In this way, mechanical properties of the swing arm and the second swing arm can be effectively improved, so that the rotating shaft mechanism can better support the first body and the second body, and the electronic device has better strength.

In a possible implementation of the first aspect, along the first direction, a ratio of a distance between the first sub-segment and the second sub-segment of the connection segment to a size of the rotating shaft mechanism is 0.05 to 0.3, for example, 0.05, 0.1, 0.2, 0.3, or the like.

Based on this, on one hand, the distance between the first sub-segment and the second sub-segment is not excessively small, so that the connection segment can better avoid the center position of the electronic device. In addition, by properly setting the distance between the first sub-segment and the second sub-segment, sufficient space can be created can be created at the center position of the electronic device for placing a component of the rotating shaft mechanism, so as to further enhance the strength at the center position of the electronic device. On the other hand, the distance between the first sub-segment and the second sub-segment is also not excessively large, so that sufficient space strength is also left at two ends of the electronic device for placing other components of the rotating shaft mechanism, thereby ensuring that the strengths at the two ends of the electronic device are not greatly weakened.

In a possible implementation of the foregoing first aspect, the at least one group of connection assembly further includes a second connection assembly and a third connection assembly, and the second connection assembly and the third connection assembly are respectively disposed on opposite sides of the connection segment of the circuit board. This further improves the connection reliability between the rotating shaft mechanism, the first body, and the second body.

In a possible implementation of the foregoing first aspect, along the first direction, distances from the second connection assembly and the third connection assembly to the center of the electronic device along the first direction are equal.

In this way, the second connection assembly and the third connection assembly can be more evenly distributed relative to the first connection assembly, thereby improving uniformity of force on the rotating shaft mechanism while satisfying a design requirement for motion trajectory of electronic device opening and closing.

In a possible implementation of the foregoing first aspect, the second connection assembly and the third connection assembly are rotationally symmetrical about the center of the electronic device along the first direction.

In this way, an entire structure of the rotating shaft mechanism may be approximately a symmetrical structure, so as to reduce types of components in the rotating shaft mechanism, reduce assembly complexity and a probability of material mismixing, and avoid a problem of increased production costs caused by excessive material stagnation.

A second aspect of this application provides a circuit board. The circuit board includes a first extension segment, a connection segment, and a second extension segment that are successively connected. The connection segment includes a first sub-segment and a second sub-segment that are disposed at an interval along the first direction. Two ends of the first sub-segment are respectively connected to the first extension segment and the second extension segment, and two ends of the second sub-segment are respectively connected to the first extension segment and the second extension segment.

In a possible implementation of the second aspect, the first extension segment includes a first end and a second end that are disposed at an interval along the first direction, and the second extension segment includes a first end and a second end that are disposed at an interval along the first direction. The two ends of the second sub-segment are respectively connected to the first end of the first extension segment and the first end of the second extension segment, and along the first direction, the second end of the first extension segment and the second end of the second extension segment are both located on a side, facing away from the second sub-segment, of the first sub-segment.

In a possible implementation of the second aspect, the circuit board includes a first trace and a second trace, and a length of the first trace is less than a length of the second trace. The first trace extends from the second end of the first extension segment to the second end of the second extension segment via the first sub-segment of the connection segment, and the first trace is configured to transmit one of the following signals: a high-speed signal and a high-current power supply signal. The second trace extends from the second end of the first extension segment to the second end of the second extension segment via the second sub-segment of the connection segment, and the second trace is configured to transmit one of the following signals: a low-speed signal, a digital signal, a small-current power supply signal, and an analog-to-digital converter signal.

In a possible implementation of the second aspect, the circuit board is a flexible printed circuit.

It may be understood that, for beneficial effects of the second aspect, reference may be made to the description in the first aspect. Details are not described herein again.

For technical effects brought by any one of the implementations of the second aspect, reference may be made to the technical effects brought by different implementations in the first aspect. Details are not described herein again.

### BRIEF DESCRIPTION OF DRAWINGS

FIG. 1A is a perspective view of a foldable mobile phone in a flattened state according to an embodiment of this application;
FIG. 1B is a perspective view of a foldable mobile phone in a folded state according to an embodiment of this application;
FIG. 1C is an exploded view of a foldable mobile phone in a flattened state according to an embodiment of this application;
FIG. 2A is a first schematic diagram of a structure of a through-shaft circuit board in a foldable mobile phone according to some technical solutions;
FIG. 2B is a second schematic diagram of a structure of a through-shaft circuit board in a foldable mobile phone according to some technical solutions;
FIG. 3A is a first schematic diagram of a structure of a through-shaft circuit board in a foldable mobile phone according to an embodiment of this application;
FIG. 3B is a second schematic diagram of a structure of a through-shaft circuit board in a foldable mobile phone according to an embodiment of this application;
FIG. 4A is a first schematic diagram of a three-point bending test for a foldable mobile phone according to the technical solutions shown in FIG. 2A and FIG. 2B;
FIG. 4B is a second schematic diagram of a three-point bending test for a foldable mobile phone according to the technical solutions shown in FIG. 2A and FIG. 2B;
FIG. 5A is a first schematic diagram of a three-point bending test for a foldable mobile phone according to an embodiment of this application;
FIG. 5B is a second schematic diagram of a three-point bending test for a foldable mobile phone according to an embodiment of this application;
FIG. 6A is a schematic diagram of a trace path of a through-shaft circuit board according to some technical solutions;
FIG. 6B is a schematic diagram of a trace path of a through-shaft circuit board according to an embodiment of this application; and
FIG. 7 is a schematic diagram of a structure of a rotating shaft mechanism according to some other technical solutions.

### DESCRIPTION OF EMBODIMENTS

To make the objectives, technical solutions, and advantages of this application clearer, the following further describes implementations of this application in detail with reference to the accompanying drawings.

This application provides a circuit board and an electronic device including the circuit board. The electronic device has good strength and good reliability.

It can be understood that the electronic device according to this application may include, but is not limited to, a foldable electronic device with a circuit board, such as a foldable mobile phone, a tablet computer, a notebook computer, an ultra-mobile personal computer (ultra-mobile personal computer, UMPC), a handheld computer, a netbook, a personal digital assistant (personal digital assistant, PDA), a wearable device, and a virtual reality device. For ease of description, an example in which the electronic device is a foldable mobile phone is used for description below. In addition, for ease of description, a state of the foldable mobile phone after being folded is defined as a folded state, a state of the foldable mobile phone after beng flattened is defined as a flattened state, and a state of the foldable mobile phone between the folded state and the flattened state is defined as an intermediate state.

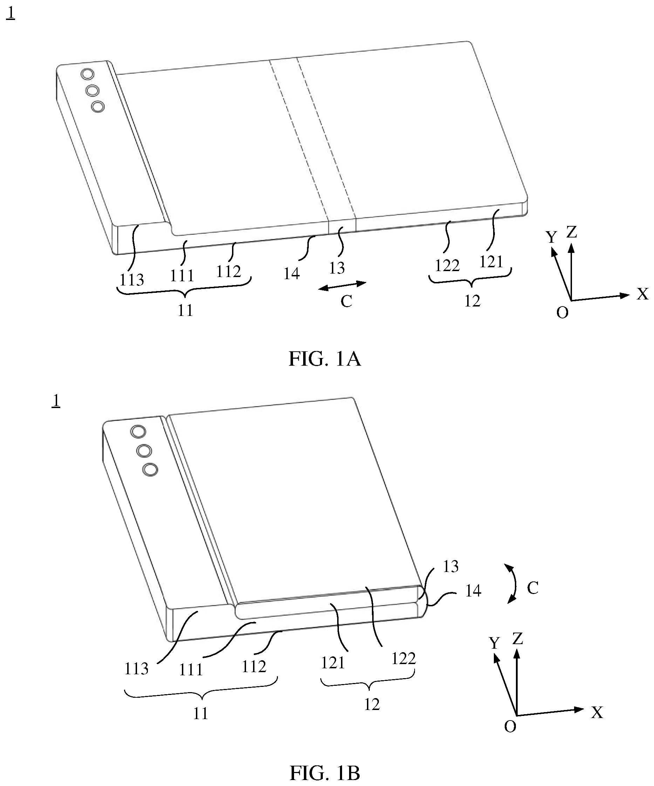

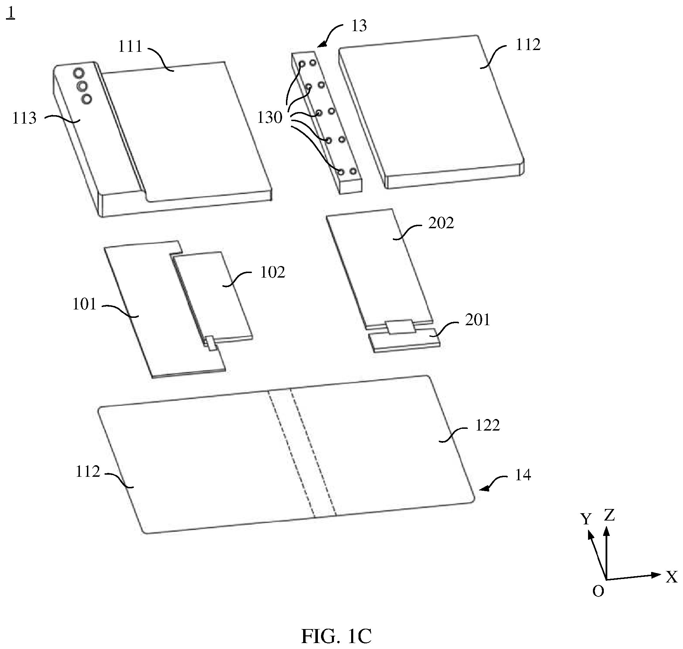

FIG. 1A to FIG. 1C show an example structure of a foldable mobile phone 1 according to an embodiment of this application. FIG. 1A is a perspective view of a foldable mobile phone 1 in a flattened state. FIG. 1B is a perspective view of a foldable mobile phone 1 in a folded state. FIG. 1C is an exploded view of a foldable mobile phone 1 in a flattened state.

To facilitate subsequent description, before a specific structure of the foldable mobile phone 1 is described, an X-axis direction, a Y-axis direction (as an example of a first direction), and a Z-axis direction corresponding to the foldable mobile phone 1 are first defined with reference to FIG. 1A to FIG. 1C. Referring to FIG. 1A to FIG. 1C, the X-axis direction is a length direction of the foldable mobile phone 1 in an unfolded state. The Z-axis direction is a thickness direction of the foldable mobile phone 1 in the unfolded state. The Y-axis direction is a direction perpendicular to both the X-axis direction and the Z-axis direction, for example, the Y-axis direction is a width direction of the foldable mobile phone 1. It should be noted that, a width of each component refers to a dimension of the component in the Y-axis direction, and a thickness of each component refers to a dimension of the component in the Z-axis direction. Details are not described below.

Referring to FIG. 1A to FIG. 1C, the foldable mobile phone 1 includes a first body 11, a second body 12, and a rotating shaft mechanism 13.

The first body 11 includes a first housing 111, a first display screen 112, and a bar-shaped protrusion 113 (or referred to as a "bar (bar)"). The first display screen 112 and the bar-shaped protrusion 113 are respectively disposed on opposite sides of the first housing 111 along the Z-axis direction. The bar-shaped protrusion 113 extends along the Y-axis direction, and projects toward a side facing away from the first display screen 112 along the Z-axis direction relative to the first housing 111. That is, a thickness of the bar-shaped protrusion 113 is greater than a thickness of the first housing 111.

The second body 12 includes a second housing 121 and a second display screen 122, and the second display screen 122 is fixed to the second housing 121. For example, the second display screen 122 and the first display screen 112 may be an integrated structure, so as to form a flexible screen 14 that can be bent.

Along the X-axis direction, the first housing 111 and the second housing 121 are respectively disposed on opposite sides of the rotating shaft mechanism 13, and are respectively connected to the rotating shaft mechanism 13. The rotating shaft mechanism 13 may include a plurality of connection assemblies 130. The plurality of connection assemblies 130 are disposed at an interval along the Y-axis direction. Each connection assembly 130 is connected to the first housing 111 of the first body 11 and the second housing 121 of the second body 12, so as to implement a rotatable connection between the first body 11 and the second body 12. It may be understood that each connection assembly 130 may be used as a fulcrum of the first body 11 and the second body 12, which is conducive to enhancing an overall deformation resistance capability of the foldable mobile phone 1.

The first housing 111 and the second housing 121 may rotate relative to each other about an axis extending along the Y-axis direction through the rotating shaft mechanism 13. The flexible screen 14 also moves accordingly and presents the flattened state or a bent state, thereby enabling the foldable mobile phone 1 to switch freely between the flattened state and the folded state.

It may be understood that the electronic device in the examples shown in FIG. 1A to FIG. 1C is a double-foldable mobile phone 1 with an outward-folding screen. That is, when the foldable mobile phone 1 is in a folded-out state, the user may observe a display interface of the flexible screen 14 from the outside of the foldable mobile phone 1. In other embodiments, the electronic device may alternatively be a device of other forms. However, this application is not limited thereto.

For example, in some embodiments, the electronic device may alternatively be a double-foldable mobile phone with an inward-folding screen. That is, when the foldable mobile phone is in a folded-in state, the user cannot observe the display interface of the flexible screen from the outside of the foldable mobile phone.

For another example, in some other embodiments, the electronic device may alternatively be a tri-foldable mobile phone. The tri-fold structure means that the foldable mobile phone includes three bodies and two rotating shaft mechanisms, and two adjacent bodies are connected to each other through one rotating shaft mechanism. The two adjacent bodies may rotate towards each other in a folded-in or folded-out manner, until an angle between the two adjacent bodies is approximately 0°, so that the foldable mobile phone is in the folded-in state or the folded-out state. The two adjacent bodies may alternatively rotate away from each other, until the angle between the two adjacent bodies is approximately 180°, so that the foldable mobile phone is in the flattened state.

The following describes the technical solutions of this application by using an example in which the electronic device is the foldable mobile phone 1 shown in FIG. 1A to FIG. 1C. Still referring to Figures 1A to 1C, in some embodiments of this application, various electronic components may be disposed inside the first body 11 and the second body 12 to implement various functions of the foldable mobile phone 1.

For example, a first circuit board 101 and a first battery 102 may be disposed in the first body 11. The first circuit board 101 may be used as a main board of the foldable mobile phone 1. For example, components such as a processor, a memory, and a communication module may be integrated on the first circuit board 101. The first battery 102 is electrically connected to the first circuit board 101, and is configured to supply power to the foldable mobile phone 1.

In addition, the bar-shaped protrusion 113 of the first body 11 may be further configured to accommodate some relatively thick electronic components (not shown), such as a camera, a motor, a universal serial bus (universal serial bus, USB) interface, and the like.

A second circuit board 201 and a second battery 202 may be disposed in the second body 12. The second circuit board 201 may be used as a secondary board of the foldable mobile phone 1. For example, components such as an adapter, a charging module, a battery level detection module, and an opening and closing detection module may be disposed on the second circuit board 201. The second battery 202 is electrically connected to the second circuit board 201, and is configured to supply power to the foldable mobile phone 1.

To enable an electronic components in the first body 11 and an electronic components in the second body 12 to perform signal transmission, the foldable mobile phone 1 further includes a through-shaft circuit board. The through-shaft circuit board is configured to connect the electronic component in the first body 11 and the electronic component in the second body 12.

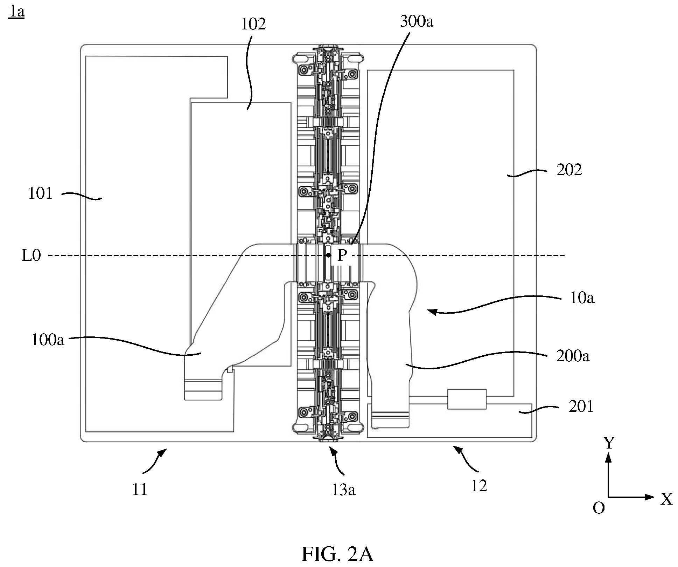

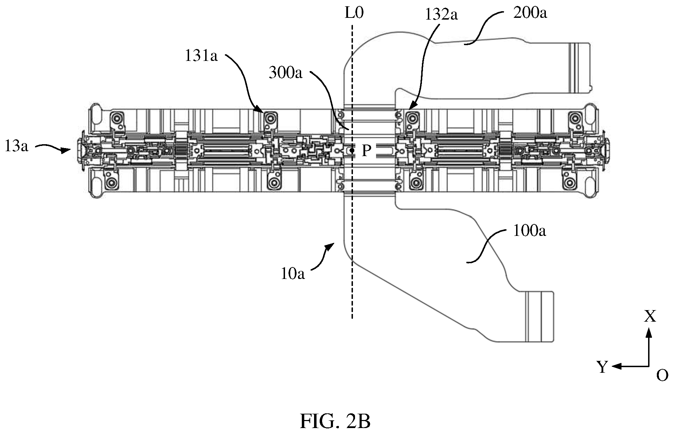

For example, FIG. 2A is a first schematic diagram of a structure of a through-shaft circuit board 10a in a foldable mobile phone 1a according to some technical solutions. FIG. 2B is a second schematic diagram of a structure of a through-shaft circuit board 10a in a foldable mobile phone 1a according to some technical solutions; Referring to FIG. 2A and FIG. 2B, in some technical solutions, the through-shaft circuit board 10a includes a first extension segment 100a, a second extension segment 200a, and a connection segment 300a. Along the X-axis direction, the first extension segment 100a and the second extension segment 200a are respectively located on opposite sides of the connection segment 300a, and are respectively connected to the connection segment 300a.

The first extension segment 100a extends to an interior of the first body 11, and is connected to the first circuit board 101. The second extension segment 200a extends to an interior of the second body 12, and is connected to the second circuit board 201. The connection segment 300a is disposed at a position corresponding to a rotating shaft mechanism 13a.

The rotating shaft mechanism 13a includes a plurality of groups of connection assemblies (for example, a first connection assembly 131a and a second connection assembly 132a). Considering that the rotating shaft mechanism 13a is a relatively expensive component in the foldable mobile phone 1a, to reduce material types, simplify an assembly process and assembly costs, and avoid waste caused by material stagnation, the plurality of groups of connection assemblies may be arranged in a form of rotation symmetry. When the plurality of groups of connection assemblies are arranged to be rotationally symmetrical, no connection assembly is arranged at a center of the foldable mobile phone 1a. Therefore, in examples shown in FIG. 2A and FIG. 2B, the connection segment 300a is arranged at a center P of the foldable mobile phone 1a along the Y-axis direction. That is, an orthographic projection of the connection segment 300a on an X-Y plane overlaps with an orthographic projection of a center line L0 of the foldable mobile phone 1a on the X-Y plane.

The connection segment 300a of the through-shaft circuit board 10a is disposed at the center P of the foldable mobile phone 1a, and occupies a relatively large space. Therefore, the rotating shaft mechanism 13a cannot arrange the connection assemblies at the center P of the foldable mobile phone 1a, and can only arrange the connection assemblies (for example, the first connection assembly 131a and the second connection assembly 132a) far away from the center P of the foldable mobile phone 1a. Consequently, support strength of the rotating shaft mechanism 13a for the first body 11 and the second body 12 at a center position of the foldable mobile phone 1a is insufficient, which in turn results in the foldable mobile phone 1a having relatively weak strength at the center position and being prone to bending deformation.

To resolve the foregoing problem, the connection segment of the circuit board in this embodiment of this application adopts a bifurcated design, so as to avoid the center position of the foldable mobile phone. In this way, a connection assembly may be arranged at a center position of the rotating shaft mechanism of the foldable mobile phone, so as to improve supporting strength of the rotating shaft mechanism at the center position of the foldable mobile phone, thereby effectively enhancing strength of the foldable mobile phone. This is described in detail below with reference to the accompanying drawings.

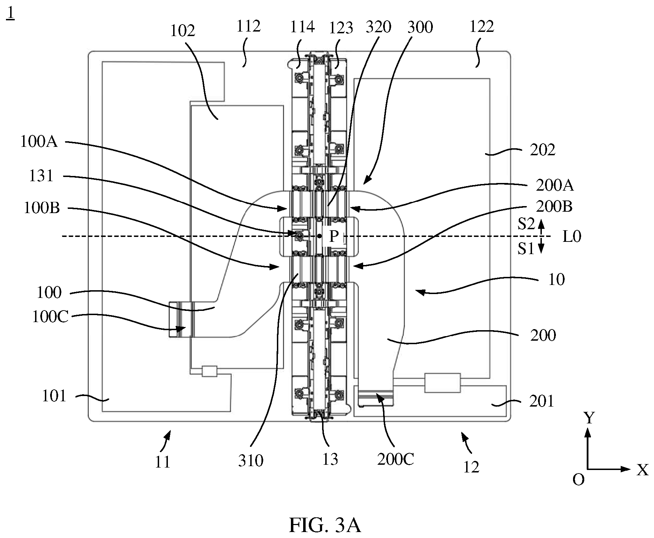

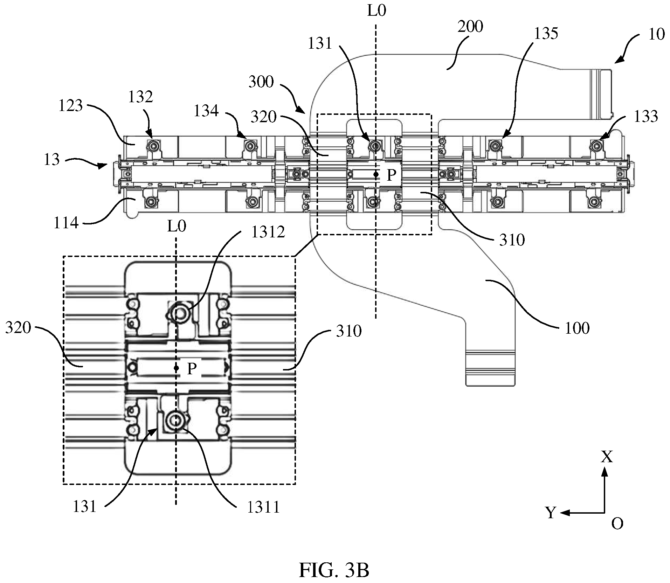

FIG. 3A is a first schematic diagram of a structure of a through-shaft circuit board 10 in a foldable mobile phone 1 according to an embodiment of this application. FIG. 3B is a second schematic diagram of a structure of a through-shaft circuit board 10 in a foldable mobile phone 1 according to an embodiment of this application. Referring to FIG. 3A and FIG. 3B, the through-shaft circuit board 10 includes a first extension segment 100, a second extension segment 200, and a connection segment 300.

The first extension segment 100 and the second extension segment 200 are disposed on opposite sides of the connection segment 300 along the X-axis direction. The connection segment 300 includes two sub-segments that are disposed at an interval along the Y-axis direction, which are respectively a first sub-segment 310 and a second sub-segment 320. Two ends of the second sub-segment 320 are respectively connected to an end 100A (as an example of a first end of the first extension segment 100) of the first extension segment 100 and an end 200A (as an example of a first end of the second extension segment 200) of the second extension segment 200. Two ends of the first sub-segment 310 are respectively connected to a middle portion 100B of the first extension segment 100 and a middle portion 200B of the second extension segment 200.

The through-shaft circuit board 10 is configured to connect the electronic component in the first body 11 and the electronic component in the second body 12. For example, the through-shaft circuit board 10 may be a flexible printed circuit (Flexible Printed Circuit, FPC). For example, the through-shaft circuit board 10 is usually made from polyimide or polyester film as a base material, and has a feature of being freely bendable, foldable, and distortable, so as to better adapt to flattening and folding of the foldable mobile phone 1.

Specifically, the first extension segment 100 of the through-shaft circuit board 10 extends to the interior of the first body 11. For example, an end 100C (as an example of a second end of the first extension segment 100) of the first extension segment 100 may be connected to the first circuit board 101 inside the first body 11.

The second extension segment 200 extends to the interior of the second body 12. For example, an end portion 200C (as an example of a second end of the second extension segment 200) of the second extension segment 200 may be connected to the second circuit board 201 inside the second body 12. In this way, the second circuit board 201 may perform signal transmission with the first circuit board 101.

The connection segment 300 extends through the rotating shaft mechanism 13. That is, the connection segment 300 is a through-shaft portion of the through-shaft circuit board 10. For example, along a circumferential direction (for example, a direction C shown in FIG. 1A and FIG. 1B) of the rotating shaft mechanism 13, the connection segment 300 extends from one end at which the rotating shaft mechanism 13 is connected to the first body 11 to one end at which the rotating shaft mechanism 13 is connected to the second body 12 through a middle portion of the rotating shaft mechanism 13. When the foldable mobile phone 1 is in the flattened state shown in FIG. 1A, the connection segment 300 is in the flattened state, has an overall shape similar to " 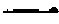 ", and extends along the direction C from one end at which the rotating shaft mechanism 13 is connected to the first body 11, through the middle portion of the rotating shaft mechanism 13, to one end at which the rotating shaft mechanism 13 is connected to the second body 12. When the foldable mobile phone 1 is in the folded state shown in FIG. 1B, the connection segment 300 is in the bent state, has an overall shape similar to "C", and extends along the direction C from one end at which the rotating shaft mechanism 13 is connected to the first body 11, through the middle portion of the rotating shaft mechanism 13, to one end at whic the rotating shaft mechanism 13 is connected to the second body 12.

In addition, along the Y-axis direction, the first sub-segment 310 and the second sub-segment 320 of the connection segment 300 are respectively located on opposite sides of the center P of the foldable mobile phone 1. It may be understood that an orthographic projection of the center P on the X-Y plane overlaps with the orthographic projection of the center line L0 of the foldable mobile phone 1 on the X-Y plane. That is, the first sub-segment 310 and the second sub-segment 320 are located on opposite sides of the center line L0 of the foldable mobile phone 1. For example, the first sub-segment 310 is located on a first side S1 of the center line L0, and the second sub-segment 320 is located on a second side S2 of the center line L0.

The rotating shaft mechanism 13 includes a first connection assembly 131. Along the Y-axis direction, the first connection assembly 131 is disposed between the first sub-segment 310 and the second sub-segment 320 of the connection segment 300, and connects the first body 11 and the second body 12, so that the first body 11 and the second body 12 can rotate relative to each other. For example, the first body 11 may include a first door panel 114 configured to support a first display screen 112, and the second body 12 may include a second door panel 123 configured to support a second display screen 122. One end of the first connection assembly 131 may be connected to the first body 11 through the first door panel 114, and the other end is connected to the second body 12 through the second door panel 123.

In the foregoing foldable mobile phone 1, the connection segment 300 of the through-shaft circuit board 10 adopts a bifurcated design, and includes a first sub-segment 310 and a second sub-segment 320. In this way, the first sub-segment 310 and the second sub-segment 320 of the connection segment 300 may be respectively disposed along the Y-axis direction on opposite sides of the center P of the foldable mobile phone 1, so that the connection segment 300 of the through-shaft circuit board 10 can avoid the center position of the foldable mobile phone 1. In this way, a connection assembly (for example, the first connection assembly 131) may be arranged at a center position of the rotating shaft mechanism 13, so as to provide a fulcrum for the center position of the foldable mobile phone 1. Therefore, support strength of the rotating shaft mechanism 13 for the first body 11 and the second body 12 at the center position of the foldable mobile phone 1 is effectively enhanced, thereby enhancing strength of the foldable mobile phone 1 at the center position. An overall deformation resistance capability is relatively good.

To understand the effect of enhancing the strength of the foldable mobile phone 1 in this embodiment of this application more intuitively, descriptions are provided below with reference to a three-point bending test and a simulation result. The three-point bending test is a test used for detecting bending strength of an electronic device.

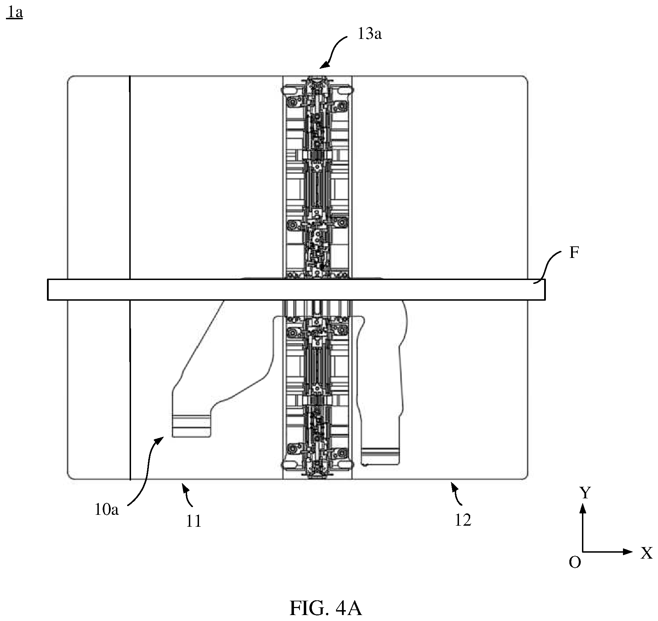

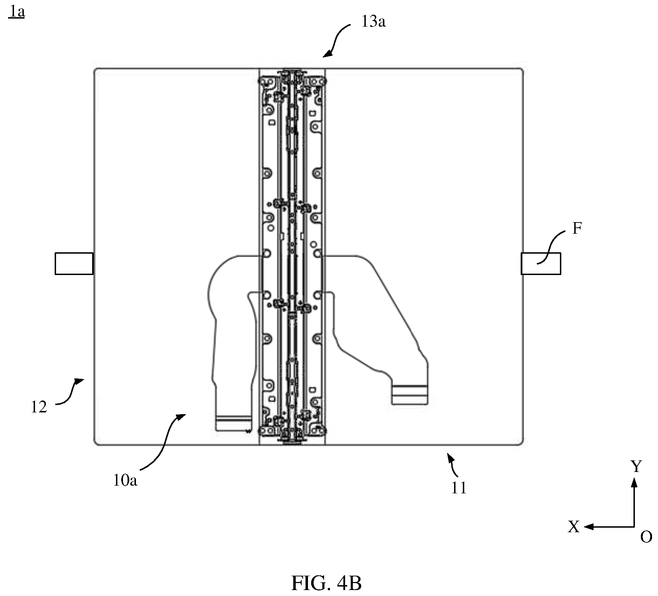

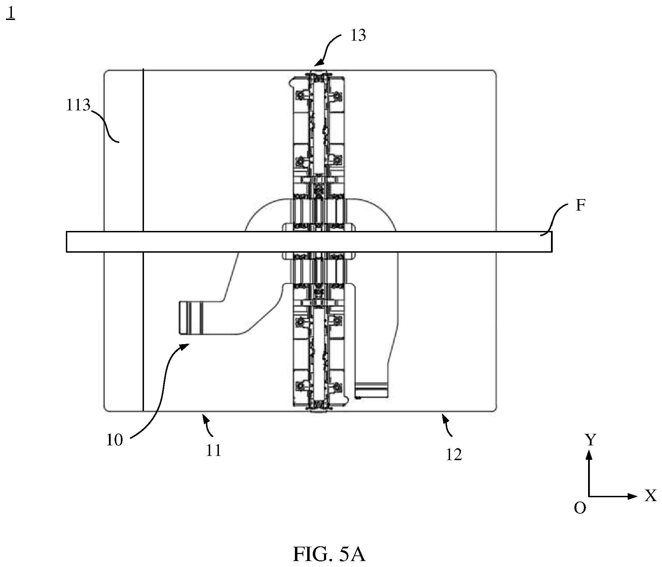

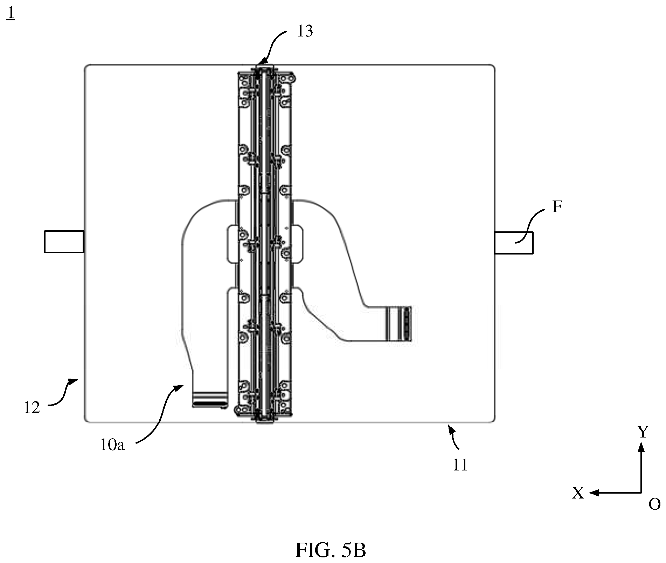

FIG. 4A and FIG. 4B are schematic diagrams of a three-point bending test for a foldable mobile phone 1a according to the technical solutions shown in FIG. 2A and FIG. 2B, where no flexible screen 14 is shown. FIG. 5A and FIG. 5B are schematic diagrams of a three-point bending test for a foldable mobile phone 1 according to an embodiment of this application, where no flexible screen 14 is shown.

Referring to FIG. 4A and FIG. 4B, a load F is applied to a center position of a front face of a foldable mobile phone 1a, and portions of the foldable mobile phone 1a may deform to different degrees. Table 1 shows example deformation amounts of the portions of the foldable mobile phone 1a.

**Table 1**

| | First body | Second body |
|---|---|---|
| Deformation amount | 0.1 mm (Values less than 0.1 mm are counted as 0.1 mm) | 4.56 mm |

Referring to Table 1 with reference to FIG. 4A and FIG. 4B, reliability of the rotating shaft mechanism 13a connected between the first body 11 and the second body 12 is relatively low, resulting in a relatively large deformation amount of the second body 12.

Referring to FIG. 5A and FIG. 5B, a load F of a same magnitude is applied to a center position of a front face of a foldable mobile phone 1, and portions of the foldable mobile phone 1 may also deform to different degrees. Table 2 shows example deformation amounts of the portions in the foldable mobile phone 1.

**Table 2**

| | First body | Second body |
|---|---|---|
| Deformation amount | 0.13 mm | 2.40 mm |

Referring to Table 2 with reference to FIG. 5A and FIG. 5B, because the through-shaft circuit board 10 adopts a bifurcated design and avoids a center position of the foldable mobile phone 1, a connection assembly (for example, the first connection assembly 131) may be arranged at a center position of the rotating shaft mechanism 13. Therefore, support strength of the rotating shaft mechanism 13 for the first body 11 and the second body 12 at the center position of the foldable mobile phone 1 can be effectively enhanced, thereby enhancing strength of the foldable mobile phone 1 at the center position. An overall deformation resistance capability is relatively good. Compared with a deformation amount of the second body 12 of the foregoing foldable mobile phone 1a, a deformation amount of the second body 12 of the foldable mobile phone 1 is greatly reduced, for example, is reduced from 4.56 mm to 2.40 mm, that is, reduced by approximately a half.

In addition, referring to FIG. 5A, FIG. 5B, and Table 2 with reference to FIG. 1A to FIG. 1C, along the X-axis direction, a bar-shaped protrusion 113 is disposed at one end, that is away from the rotating shaft mechanism 13, of the first body 11. The bar-shaped protrusion 113 is relatively thick, and can provide some support for the first body 11. Therefore, a deformation amount of the first body 11 is relatively small.

The following continues to further describe specific structures and example disposition manners of the through-shaft circuit board 10 and the rotating shaft mechanism 13 with reference to the accompanying drawings.

Still referring to FIG. 3A, along the Y-axis direction, an end 100A and an end 100C of the first extension segment 100 are disposed at an interval, and an end 200A and an end 200C of the second extension segment 200 are disposed at an interval. The end 100C and the end 200C are both located on a side, facing away from the second sub-segment 320, of the first sub-segment 310. That is, at least some of the first extension segment 100 and the second extension segment 200 extend along the Y-axis direction to the side, facing away from the second sub-segment 320, of the first sub-segment 310. For example, the first extension segment 100 may extend along a negative Y-axis direction to a position that is at approximately one quarter of the foldable mobile phone 1, so as to be connected to the first circuit board 101. The second extension segment 200 may extend along the negative Y-axis direction to a position that is close to the bottom of the foldable mobile phone 1, so as to be connected to the second circuit board 201.

After the end 200A of the second extension segment 200 is extended to the position that is close to the bottom of the foldable mobile phone 1, the second circuit board 201 may also be disposed at the position that is close to the bottom of the foldable mobile phone 1. Therefore, more space is reserved for the second battery 202 in the Y-axis direction, so as to improve a length of the second battery 202, thereby improving capacity of the second battery 202 when thickness space is limited. This facilitates a thinning design of the foldable mobile phone 1, and can also satisfy a requirement of the foldable mobile phone 1 for a battery capacity.

In addition, because the connection segment 300 of the through-shaft circuit board 10 is divided into the first sub-segment 310 and the second sub-segment 320, an entire width of the connection segment 300 can be set to be relatively large while ensuring that widths of the first sub-segment 310 and the second sub-segment 320 are not excessively large. In this way, a width and a length of the through-shaft circuit board 10 can be matched to reduce an impedance of the through-shaft circuit board 10, thereby improving a signal transmission effect. Meanwhile, the rotating shaft mechanism 13 does not need to leave relatively large space to avoid the first sub-segment 310 and the second sub-segment 320, thereby ensuring strength of the foldable mobile phone 1.

For example, as shown in FIG. 2A, the length and the width of the through-shaft circuit board 10a are both relatively large. This may result in a larger area that needs to be avoided at the center position of the rotating shaft mechanism 13a, thereby further reducing the strength of the foldable mobile phone 1a. However, in this application, the connection segment 300 of the through-shaft circuit board 10 adopts a bifurcated design, and includes a first sub-segment 310 and a second sub-segment 320. Compared with the connection segment 300a of the through-shaft circuit board 10a, the widths of the first sub-segment 310 and the second sub-segment 320 are greatly reduced (for example, reduced by half) and reliability of the rotating shaft mechanism 13 is better. This improves the strength of the foldable mobile phone 1, and can also satisfy a design requirement of reducing the impedance of the through-shaft circuit board 10, thereby improving the signal transmission effect.

In some embodiments of this application, the through-shaft circuit board 10 may properly allocate a trace path by using the first sub-segment 310 and the second sub-segment 320, so that a signal greatly affected by a trace length (for example, a high-speed signal (such as a signal whose frequency is greater than or equal to 100 MHz), or a high-current power supply signal (such as a signal whose current is greater than or equal to 0.5 A)) corresponds to a relatively small trace length, and a signal insensitive to the trace length (for example, a low-speed signal (such as a signal whose frequency is less than 100 MHz), a digital signal, a low-current power supply signal (such as a signal whose current is less than 0.5 A), or an analog-to-digital converter (analog-to-digital converter, ADC) signal) corresponds to a relatively large trace length, thereby further optimizing a trace impedance and improving the signal transmission effect.

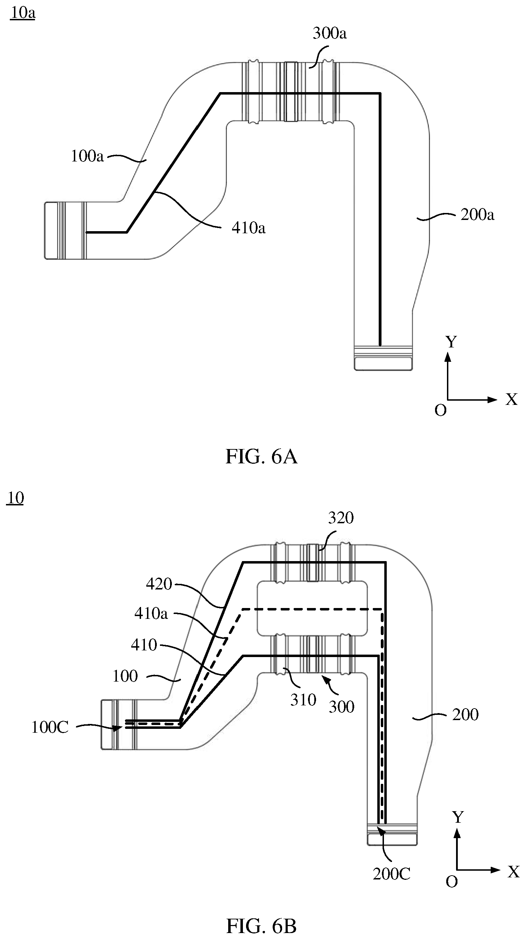

Specifically, FIG. 6A is a schematic diagram of a trace path of a through-shaft circuit board 10a according to some technical solutions. FIG. 6B is a schematic diagram of a trace path of a through-shaft circuit board 10 according to an embodiment of this application. For ease of observation, a first trace 410a of the through-shaft circuit board 10a is shown by a dashed line.

Referring to FIG. 6A, in some technical solutions, the through-shaft circuit board 10a includes the first trace 410a. The first trace 410a extends from a first extension segment 100a to a second extension segment 200a through a connection segment 300a. The first trace 410a is configured to transmit various types of signals. For a signal (for example, a high-speed signal or a high-current power supply signal) greatly affected by a trace length, a trace length of the first trace 410a is relatively long. Therefore, a parasite induction, a parasite capacitance, and a low-frequency impedance of the first trace 410a are relatively large. Consequently, quality, a voltage drop, and the like of a signal transmitted by the first trace 410a are greatly affected, and the signal transmission effect is poor.

Referring to FIG. 6B, in this embodiment of this application, the through-shaft circuit board 10 includes a first trace 410 and a second trace 420that are, for example, shown by solid lines in FIG. 6B. A length of the first trace 410 is less than a length of the second trace 420.

For example, the first trace 410 may extend from an end 100C of a first extension segment 100 to an end 200C of a second extension segment 200 via a first sub-segment 310 of the connection segment 300. The second trace 420 may extend from the end 100C of the first extension segment 100 to the end 200C of the second extension segment 200 via a second sub-segment 320 of the connection segment 300.

The first trace 410 is configured to transmit a first signal. The first signal is a signal greatly affected by the trace length. For example, the first signal may include, but is not limited to, a high-speed signal or a high-current power supply signal. The second trace 420 is configured to transmit a second signal. The second signal is a signal less affected by the trace length. For example, the second signal may include, but is not limited to, a low-speed signal, a digital signal, a small-current power supply signal, an analog-to-digital converter signal, or the like.

In the foregoing through-shaft circuit board 10, because the length of the first trace 410 is relatively small, a parasite induction, a parasite capacitance, and a low-frequency impedance can be effectively reduced, which is conducive to improving a transmission effect of the first signal. The second signal is insensitive to the trace length. Therefore, even if the length of the second trace 420 is relatively long, this does not affect an actual functional module or actual detection.

Compared with FIG. 6A and FIG. 6B, in this embodiment of this application, trace paths of different signals are properly designed by using the first sub-segment 310 and the second sub-segment 320, so that the length of the first trace 410 can be reduced by about 20% compared with the length of the first trace 410a. Therefore, a trace impedance of the first trace 410 can also be optimized by greater than about 20% compared with a trace impedance of the first trace 410a, which is more beneficial to transmission of the first signal greatly affected by the trace length. In conclusion, compared with the through-shaft circuit board 10a, a trace impedance design of the through-shaft circuit board 10 provided in this embodiment of this application is more appropriate, and an overall transmission effect of signal is better.

In some embodiments of this application, the high-speed signal may include a camera mobile industry processor interface (camera mobile industry processor interface, Camera MIPI) signal, a display mobile industry processor interface (display mobile industry processor interface, Display MIPI) signal, a differential input signal (for example, D + or D-) of a universal serial bus (universal serial bus, USB), or the like.

In some embodiments of this application, the high-current power supply signal may include a voltage bus signal (voltage bus, VBUS), a voltage of battery signal (voltage of battery, VBAT), a system power supply signal (VPH-power), a voltage of system signal (voltage of system, VSYS), a positive power supply voltage output signal (ELVDD), a negative power supply voltage output signal (ELVSS), a speaker signal (for example, SPK + or SPK-), or the like.

In some embodiments of this application, the low-speed signal may include a general purpose input output (GPIO) signal, an enable signal, a detect signal, or the like.

In some embodiments of this application, the digital signal may include an inter integrated circuit interface (inter integrated circuit, I2C) signal, an improved inter integrated circuit interface (improved inter integrated circuit, I3C) signal, a serial peripheral interface (serial peripheral interface, SPI) bus signal, or the like.

In some embodiments of this application, the small current power supply signal may include an input/output (input/output, I/O) power supply signal, a motor power supply signal, or the like.

In some embodiments of this application, the analog-to-digital converter signal may include a detection (identification, ID) signal.

Still referring to FIG. 3A and FIG. 3B, in some embodiments of this application, a first connection assembly 131 is located at the center P of the foldable mobile phone 1 along the Y-axis direction. That is, an orthographic projection of the first connection assembly 131 on the X-Y plane overlaps at least partially with the orthographic projection of the center line L0 of the foldable mobile phone 1 on the X-Y plane. In this way, connection reliability of the rotating shaft mechanism 13, the first body 11, and the second body 12 at the center position of the foldable mobile phone 1 can be further improved, so that the foldable mobile phone 1 has better strength and a better deformation resistance capability.

In some embodiments of this application, the first connection assembly 131 includes a first swing arm 1311 and a second swing arm 1312. The first connection assembly 131 is connected to the first body 11 (for example, connected to the first door panel 114 configured to support the first display screen 112) through the first swing arm 1311, and is connected to the second body 12 (for example, connected to the second door panel 123 configured to support the second display screen 122) through the second swing arm 1312. Moreover, both the first swing arm 1311 and the second swing arm 1312 can rotate about an axis extending along the Y-axis direction, so that the first body 11 and the second body 12 can rotate relative to each other.

In some embodiments of this application, a material of the first swing arm 1311 and the second swing arm 1312 may be a powder metallurgy material. Therefore, mechanical properties of the first swing arm 1311 and the second swing arm 1312 can be effectively improved, thereby improving support strength of the rotating shaft mechanism 13 for the first body 11 and the second body 12, so that the foldable mobile phone 1 has better strength.

In some of the implementations, the first swing arm 1311 and the second swing arm 1312 may be molded by means of metal injection molding (metal injection molding, MIM), so that the first swing arm 1311 and the second swing arm 1312 have higher production efficiency, and lower manufacturing costs.

In some other embodiments of this application, the material of the first swing arm 1311 and the second swing arm 1312 may alternatively be a material that can be processed by using a computer numerical control machine tool (computer numerical control machine tool, CNC), for example, profiled Aluminum. This can effectively improve mechanical properties of the first swing arm 1311 and the second swing arm 1312, thereby improving the supporting strength of the rotating shaft mechanism 13 for the first body 11 and the second body 12, so that the foldable mobile phone 1 has better strength.

In some other embodiments of this application, the material of the first swing arm 1311 and the second swing arm 1312 may alternatively be a material that can be die-cast. That is, the first swing arm 1311 and the second swing arm 1312 may alternatively be die-cast parts.

In some embodiments of this application, the first swing arm 1311 and the second swing arm 1312 may be respectively fixedly connected to the first door panel 114 and the second door panel 123 through a fastener (for example, a screw), so as to further enhance connection reliability between the rotating shaft mechanism 13, and the first body 11 and the second body 12, so that the foldable mobile phone 1 has better strength.

In some embodiments of this application, along the Y-axis direction, connection assemblies may also be disposed at opposite sides of the connection segment 300 of the through-shaft circuit board 10, to further improve the connection reliability between the rotating shaft mechanism 13, and the first body 11 and the second body 12.

For example, still referring to FIG. 3A and FIG. 3B, in addition to the first connection assembly 131, the rotating shaft mechanism 13 may further include four connection assemblies, respectively: a second connection assembly 132, a third connection assembly 133, a fourth connection assembly 134, and a fifth connection assembly 135. Along the Y-axis direction, the second connection assembly 132 and the third connection assembly 133 are respectively disposed on opposite sides of the connection segment 300 of the through-shaft circuit board 10, and the fourth connection assembly 134 and the fifth connection assembly 135 are respectively disposed on opposite sides of the connection segment 300 of the through-shaft circuit board 10. In addition, the second connection assembly 132 and the fourth connection assembly 134 are located on a same side of the connection segment 300 of the through-shaft circuit board 10, and the third connection assembly 133 and the fifth connection assembly 135 are located on a same side of the connection segment 300 of the through-shaft circuit board 10.

Specific structural forms of the second connection assembly 132, the third connection assembly 133, the fourth connection assembly 134, and the fifth connection assembly 135 are consistent with the specific structural form of the first connection assembly 131. Therefore, reference may be made to the foregoing related descriptions about the first connection assembly 131, and details are not described herein again.

In some embodiments of this application, along the Y-axis direction, a distance from the second connection assembly 132 to the center P may be equal to a distance from the third connection assembly 133 to the center P. In this way, the second connection assembly 132 and the third connection assembly 133 can be more evenly distributed relative to the first connection assembly 131, thereby improving uniformity of force on the rotating shaft mechanism 13, and satisfying a supporting requirement for the first display screen 112 and the second display screen 122, as well as a design requirement for motion trajectory of opening and closing of the foldable mobile phone 1, so that opening and closing experience is good.

Similarly, in some embodiments of this application, along the Y-axis direction, a distance from the fourth connection assembly 134 to the center P may also be equal to a distance from the fifth connection assembly 135 to the center P. In this way, the fourth connection assembly 134 and the fifth connection assembly 135 can be more evenly distributed relative to the first connection assembly 131, thereby further improving the uniformity of force on the rotating shaft mechanism 13, and satisfying the supporting requirement for the first display screen 112 and the second display screen 122, as well as the design requirement for motion trajectory of opening and closing of the foldable mobile phone 1, so that the opening and closing experience is good.

In some embodiments of this application, the second connection assembly 132 and the third connection assembly 133 are rotationally symmetrical relative to the center P, and the fourth connection assembly 134 and the fifth connection assembly 135 are rotationally symmetrical relative to the center P.

For example, after rotating 180° about the center P, the second connection assembly 132 may completely coincide with the third connection assembly 133, and after rotating 180° about the center P, the fourth connection assembly 134 may completely coincide with the fifth connection assembly 135.

In this way, an entire structure of the rotating shaft mechanism 13 may be approximately a structure that is symmetrical about the connection segment 300 of the through-shaft circuit board 10, so that types of components in the rotating shaft mechanism 13 can be effectively reduced, assembly is relatively simple, and production costs are low.

In some embodiments of this application, along the Y-axis direction, a ratio of a distance between the first sub-segment 310 and the second sub-segment 320 of the through-shaft circuit board 10 to a size of the rotating shaft mechanism 13 may be 0.05 to 0.3, for example, 0.05, 0.1, 0.2, 0.3, or the like.

Based on this, on one hand, the distance between the first sub-segment 310 and the second sub-segment 320 is not excessively small, so that the connection segment 300 can better avoid the center P of the foldable mobile phone 1. In addition, by properly setting a distance between the first sub-segment 310 and the second sub-segment 320, sufficient space can be created can be created at the center position of the foldable mobile phone 1 for placing a component (for example, the first connection assembly 131) of the rotating shaft mechanism 13, so as to further enhance the strength at the center position of the foldable mobile phone 1. On the other hand, the distance between the first sub-segment 310 and the second sub-segment 320 is also not excessively large, so that sufficient space strength is also left at two ends of the foldable mobile phone 1 for placing other components (for example, the second connection assembly 132, the third connection assembly 133, and the like) of the rotating shaft mechanism 13, thereby ensuring that the strengths at the two ends of the foldable mobile phone 1 are not greatly weakened.

The foregoing exemplarily describes a disposition manner of components of the rotating shaft mechanism 13 relative to the through-shaft circuit board 10. However, this application is not limited thereto. In another embodiment, each component of the rotating shaft mechanism 13 may alternatively be disposed in another manner.

For example, in the examples shown in FIG. 3A and FIG. 3B, the rotating shaft mechanism 13 includes five groups of connection assemblies. In another example, the rotating shaft mechanism 13 may include another number of connection assemblies, for example, three groups, seven groups, or the like. It may be understood that a larger number of connection assemblies indicates a better supporting performance of the rotating shaft mechanism 13 for the first body 11 and the second body 12. In addition, a plurality of groups of connection assemblies may be disposed at equal intervals or substantially at equal intervals, to provide support to the first body 11 and the second body 12 as evenly as possible.

Specifically, in this embodiment, the connection segment 300 of the through-shaft circuit board 10 includes a first sub-segment 310 and a second sub-segment 320, and the rotating shaft mechanism 13 includes a connection assembly, for example, the first connection assembly 131, disposed between the first sub-segment 310 and the second sub-segment 320. In some other embodiments, more connection assemblies, for example, two, three, or four, may be disposed between the first sub-segment 310 and the second sub-segment 320 for the rotating shaft mechanism 13. In some other embodiments, the connection segment 300 of the through-shaft circuit board 10 may further include more sub-segments (for example, three, four, five, or the like), and a connection assembly of the rotating shaft mechanism 13 is disposed between each two adjacent sub-segments.

For another example, in this embodiment, the rotating shaft mechanism 13 includes four connection assemblies, for example, a second connection assembly 132, a third connection assembly 133, a fourth connection assembly 134, and a fifth connection assembly 135, that are respectively disposed on opposite sides of the connection segment 300 of the through-shaft circuit board 10. In some other embodiments, more or fewer connection assemblies may alternatively be disposed on opposite sides of the connection segment 300 of the through-shaft circuit board 10. For example, the rotating shaft mechanism 13 may include the second connection assembly 132 and the third connection assembly 133, and not include the fourth connection assembly 134 and the fifth connection assembly 135. Along the Y-axis direction, the second connection assembly 132 and the third connection assembly 133 are respectively disposed on opposite sides of the connection segment 300 of the through-shaft circuit board 10.

The following describes the comparison between the rotating shaft mechanisms provided in the embodiments of this application with rotating shaft mechanisms in some other technical solution with reference to the accompanying drawings.

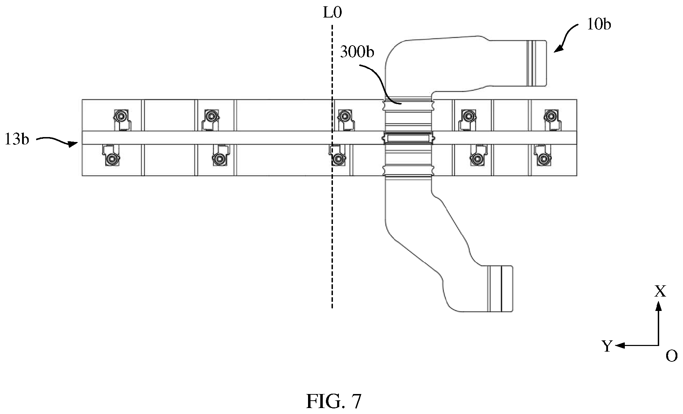

FIG. 7 is a schematic diagram of a structure of a rotating shaft mechanism 13b according to some other technical solutions. Referring to FIG. 7, in some other technical solutions, the connection segment 300b of the through-shaft circuit board 10b is located on the right side of the center line L0. Because the rotating shaft mechanism 13b needs to avoid an offset through-shaft circuit board 10b, it is difficult to make an entire structure of the rotating shaft mechanism 13b be symmetrical. Consequently, there are many types of components of the rotating shaft mechanism 13b, assembly is complex, and a material mismixing probability is high. In addition, some materials easily have problems of excessive inventory, extremely small consumption, and extremely low stock turnover rate (that is, material stagnation), leading to relatively high production costs.

Compared with FIG. 3B and FIG. 7, in this application, the first sub-segment 310 and the second sub-segment 320 of the connection segment 300 of the through-shaft circuit board 10 are respectively disposed along the Y-axis direction on opposite sides of the center P, which facilitates a symmetrical design of the rotating shaft mechanism 13. For example, connection assemblies (for example, a second connection assembly 132, a third connection assembly 133, a fourth connection assembly 134, and a fifth connection assembly 135) located on opposite sides of the through-shaft circuit board 10 in the rotating shaft mechanism 13 can be rotationally symmetrically arranged about the center P. In this way, an entire structure of the rotating shaft mechanism 13 may be approximately a structure that is symmetrical about the connection segment 300 of the through-shaft circuit board 10, so as to reduce types of components in the rotating shaft mechanism 13, reduce assembly complexity and a probability of material mismixing, and avoid a problem of increased production costs caused by excessive material stagnation.

The implementations of this application are described above by specific embodiments, and a person skilled in the art can easily understand other advantages and effects of this application from content disclosed in this specification. Although the descriptions of this application are provided with reference to some embodiments, it does not mean that the features of this application are limited to the implementations. On the contrary, the purpose of describing this application with reference to the implementations is to cover other options or modifications that may be extended based on the claims of this application. This application may be practiced without these details. In addition, to avoid confusing or blurring emphasis of this application, some specific details are omitted in the description. It should be noted that the embodiments in this application and the features in embodiments may be combined with each other in a case that no conflict occurs.

In the descriptions of this application, it should be noted that an orientation or positional relationship indicated by the term "central", "upper", "lower", "left", "right", "vertical", "horizontal", "outer", "inner", "circumferential", "radial", "axial", or the like is based on the orientation or positional relationship shown in the accompanying drawings, which is only for convenience of describing this application and simplifying the description, rather than indicating or implying that the referred apparatus or element needs to have a particular orientation, be constructed and operated in a particular orientation, and therefore should not be construed as limiting this application.

In the description of this application, it should be noted that unless otherwise explicitly specified or defined, the terms such as "dispose", "mount", "install", "connect", and "fit" should be understood in a broad sense. For example, the connection may be a fixed connection, a detachable connection, or an integral connection; or the connection may be a mechanical connection or an electrical connection; or the connection may be a direct connection, an indirect connection through an intermediary, or internal communication between two components. For a person of ordinary skill in the art, the specific meanings of the terms mentioned above in this application can be construed according to specific circumstances.

Obviously, a person skilled in the art can make various modifications and variations to this application without departing from the spirit and scope of this application. In this case, if the modifications and variations made to this application fall within the scope of the claims of this application and their equivalent technologies, this application is intended to include these modifications and variations.

## Claims

1. An electronic device, comprising a first body, a second body, a rotating shaft mechanism, and a circuit board, wherein
the first body is connected to the second body through the rotating shaft mechanism, to rotate relative to the second body about an axis extending along a first direction, the rotating shaft mechanism comprises at least one group of connection assembly that rotatably connects the first body and the second body, and the at least one group of connection assembly comprises a first connection assembly;
the circuit board comprises a first extension segment, a connection segment, and a second extension segment that are successively connected, the connection segment comprises a first sub-segment and a second sub-segment that are disposed at an interval along the first direction, two ends of the first sub-segment are respectively connected to the first extension segment and the second extension segment, and two ends of the second sub-segment are respectively connected to the first extension segment and the second extension segment;
the first extension segment and the second extension segment respectively extend into the first body and the second body, the connection segment extends through the rotating shaft mechanism, and along the first direction, the first sub-segment and the second sub-segment of the connection segment are respectively located on opposite sides of a center of the electronic device along the first direction; and
the first connection assembly is disposed between the first sub-segment and the second sub-segment of the connection segment along the first direction.

2. The electronic device according to claim 1, wherein the first extension segment comprises a first end and a second end that are disposed at an interval along the first direction, and the second extension segment comprises a first end and a second end that are disposed at an interval along the first direction; and
the two ends of the second sub-segment are respectively connected to the first end of the first extension segment and the first end of the second extension segment, and along the first direction, the second end of the first extension segment and the second end of the second extension segment are both located on a side, facing away from the second sub-segment, of the first sub-segment.

3. The electronic device according to claim 2, wherein the circuit board comprises a first trace and a second trace, and a length of the first trace is less than a length of the second trace,
the first trace extends from the second end of the first extension segment to the second end of the second extension segment via the first sub-segment of the connection segment, and the first trace is configured to transmit one of the following signals: a high-speed signal or a high-current power supply signal; and
the second trace extends from the second end of the first extension segment to the second end of the second extension segment via the second sub-segment of the connection segment, and the second trace is configured to transmit one of the following signals: a low-speed signal, a digital signal, a small-current power supply signal, or an analog-to-digital converter signal.

4. The electronic device according to claim 1, wherein the circuit board is a flexible printed circuit.

5. The electronic device according to claim 1, wherein the first connection assembly is located at the center of the electronic device along the first direction.

6. The electronic device according to claim 5, wherein the first connection assembly comprises a first swing arm and a second swing arm, and the first connection assembly is connected to the first body through the first swing arm, and is connected to the second body through the second swing arm; and a material of the first swing arm and the second swing arm is a powder metallurgy material or an aluminum profile.

7. The electronic device according to claim 1, wherein along the first direction, a ratio of a distance between the first sub-segment and the second sub-segment of the connection segment to a size of the rotating shaft mechanism is 0.05 to 0.3.

8. The electronic device according to claim 1, wherein the at least one group of connection assembly further comprises a second connection assembly and a third connection assembly, and the second connection assembly and the third connection assembly are respectively disposed on opposite sides of the connection segment of the circuit board.

9. The electronic device according to claim 8, wherein along the first direction, distances from the second connection assembly and the third connection assembly to the center of the electronic device along the first direction are equal.

10. The electronic device according to claim 8, wherein the second connection assembly and the third connection assembly are rotationally symmetrical about the center of the electronic device along the first direction.

11. A circuit board, comprising a first extension segment, a connection segment, and a second extension segment that are successively connected, wherein the connection segment comprises a first sub-segment and a second sub-segment that are disposed at an interval along a first direction, two ends of the first sub-segment are respectively connected to the first extension segment and the second extension segment, and two ends of the second sub-segment are respectively connected to the first extension segment and the second extension segment.

12. The circuit board according to claim 11, wherein the first extension segment comprises a first end and a second end that are disposed at an interval along the first direction, and the second extension segment comprises a first end and a second end that are disposed at an interval along the first direction; and
the two ends of the second sub-segment are respectively connected to the first end of the first extension segment and the first end of the second extension segment, and along the first direction, the second end of the first extension segment and the second end of the second extension segment are both located on a side, facing away from the second sub-segment, of the first sub-segment.

13. The circuit board according to claim 12, wherein the circuit board comprises a first trace and a second trace, and a length of the first trace is less than a length of the second trace,
the first trace extends from the second end of the first extension segment to the second end of the second extension segment via the first sub-segment of the connection segment, and the first trace is configured to transmit one of the following signals: a high-speed signal or a high-current power supply signal; and
the second trace extends from the second end of the first extension segment to the second end of the second extension segment via the second sub-segment of the connection segment, and the second trace is configured to transmit one of the following signals: a low-speed signal, a digital signal, a small-current power supply signal, or an analog-to-digital converter signal.

14. The circuit board according to claim 11, wherein the circuit board is a flexible printed circuit.
